# EUROPEAN PATENT APPLICATION

(11) **EP 4 498 418 A1**
(43) Date of publication of application: **29.01.2025**
(21) Application number: 22963181.7
(22) Date of filing: 28.10.2022
(51) Int. Cl.: H01L 21/786

(54) **DISPLAY SUBSTRATE AND DISPLAY APPARATUS**

(71) Applicant: BOE Technology Group Co., Ltd., Beijing 100015 (CN)
(72) Inventor: XUE, Jinxiang, Beijing 100176 (CN); SUN, Zhongyuan, Beijing 100176 (CN); LIU, Wenqi, Beijing 100176 (CN); AN, Che, Beijing 100176 (CN); WANG, Weijie, Beijing 100176 (CN); ZHANG, Fengjie, Beijing 100176 (CN); LIU, Fang, Beijing 100176 (CN)
(74) Representative: Isarpatent
(86) International application number: PCT/CN2022/128364
(87) International publication number: WO 2024/087199

(57) **Abstract**

A display substrate and a display device relate to the technical field of displaying. The display substrate includes a plurality of display units spaced apart from each other and a plurality of connecting units, the plurality of connecting units being connected between two adjacent display units; the plurality of connecting units including: two connecting units arranged along a first direction, wherein the first direction is parallel to a stretching direction of the display substrate; wherein the two connecting units arranged along the first direction are axisymmetric about a first reference line, so that the plurality of connecting units arranged along a second direction have a same deformation amount in a stretching state, the second direction is perpendicular to the stretching direction, and an extension direction of the first reference line is parallel to the second direction.

## Description

### TECHNICAL FIELD

The present disclosure relates to the technical field of display and, more particularly, to a display substrate and a display device.

### BACKGROUND

At present, a flat panel display device with excellent characteristics for example thin and low power consumption exists. Recently, a flexible display device with bendable and foldable characteristics is being actively developed. Further, a shape-changeable stretchable display device is also a development direction of display technologies in the future.

### SUMMARY

A display substrate is provided in the present disclosure, which includes: a plurality of display units spaced apart from each other and a plurality of connecting units, the plurality of connecting units being connected between two adjacent display units;
the plurality of connecting units includes: two connecting units arranged along a first direction, the first direction being parallel to a stretching direction of the display substrate; and
wherein the two connecting units arranged along the first direction are axisymmetric about a first reference line, to make the plurality of connecting units arranged along a second direction have a same deformation amount under a stretching state, the second direction is perpendicular to the stretching direction, and an extension direction of the first reference line is parallel to the second direction.

According to some embodiments, the plurality of connecting units further include: two connecting units arranged along the second direction, and the two connecting units arranged along the second direction are axisymmetric about a second reference line, and an extension direction of the second reference line is parallel to the first direction.

According to some embodiments, the two connecting units are connected to a same display unit, and the same display unit has two side edges disposed oppositely in an arrangement direction of the two connecting units, and the two connecting units are connected to different side edges of the two side edges respectively.

According to some embodiments, the connecting unit includes a first connection line and a second connection line, the first connection line and the second connection line are connected to a same side edge of a same display unit, and are connected to a same position on the same side edge.

According to some embodiments, the same position is located at a midpoint of the same side edge.

According to some embodiments, the first connection line is bend towards a side away from the second connection line, and the second connection line is bend towards a side away from the first connection line.

According to some embodiments, the connecting unit includes a third connection line and a fourth connection line, the third connection line and the fourth connection line are connected to a same side edge of a same display unit, and are connected to different positions on the same side edge.

According to some embodiments, the third connection line and the fourth connection line are connected to different endpoints of the same side edge respectively.

According to some embodiments, the third connection line is bend towards a side close to the fourth connection line, and the fourth connection line is bend towards a side close to the third connection line.

According to some embodiments, the connecting unit includes two connection lines, the two connection lines are axisymmetric about a third reference line, and an extension direction of the third reference line is parallel to an arrangement direction of the two display units connected by each of the connection lines.

According to some embodiments, the display substrate includes at least one symmetric unit, the symmetric unit at least includes a first display unit and a second display unit, an arrangement direction of the first display unit and the second display unit is parallel to an arrangement direction of the two connecting units;
wherein the first display unit has a first side edge away from the second display unit, the second display unit has a second side edge away from the first display unit, and the two connecting units are connected to the first side edge and the second side edge respectively.

According to some embodiments, a shape of the display unit is a polygon, the connecting unit includes a fifth connection line, and the fifth connection line is connected to a vertex of the polygon.

According to some embodiments, a shape of the display unit is a polygon, and a plurality of vertexes of the polygon are connected to the different connecting units respectively.

According to some embodiments, the first display unit and the second display unit are two adjacent display units.

According to some embodiments, the connecting unit each includes a fifth connection line, a shape of the fifth connection line is a U-shaped, U-shaped openings of the two adjacent fifth connection lines face different directions respectively.

According to some embodiments, at least one display unit is further disposed between the first display unit and the second display unit.

According to some embodiments, the connecting unit includes at least one connection line, each of the connection lines are connected to the two adjacent display units, and a shape of the connection line includes at least one of the following: a U-shaped and an S-shaped.

According to some embodiments, the display substrate further includes a hollow area, the hollow area is located between the display unit and the connecting unit, and among the plurality of the connecting units, and the hollow area penetrates through the display substrate in a normal direction of the display substrate.

A display device is provided in the present disclosure, which includes
the display substrate according to any one of the embodiments stated above;
a driving integrated circuit, configured to provide a driving signal to the display substrate; and
a power supply circuit, configured to provide a power supply to the display substrate.

According to some embodiments, the display substrate further includes a hollow area, the hollow area penetrates through the display substrate in a normal direction of the display substrate;
the display device further includes:
a flexible substrate disposed on at least one side of the display substrate; and
an adhesive layer disposed between the display substrate and the flexible substrate;
wherein an orthographic projection of the adhesive layer on the display substrate does not overlap with the connecting unit and the hollow area.

The above description is merely a summary of the technical solutions of the present disclosure. In order to more clearly understand the technical means of the present disclosure to enable the implementation according to the content of the description, and to make the above-mentioned and other purposes, features and advantages of the present disclosure more apparent and understandable, the particular embodiments of the present disclosure are provided below.

### BRIEF DESCRIPTION OF THE DRAWINGS

In order to more clearly illustrate the technical solutions of the embodiments of the present disclosure or the related art, the figures that are required to describe the embodiments or the related art will be briefly introduced below. Apparently, the figures that are described below are some embodiments of the present disclosure, and a person skilled in the art may obtain other figures according to these figures without paying creative work. It should be noted that, the proportion in the drawings is merely indicative and does not represent actual proportion.
FIG. 1 schematically shows a schematic diagram of a planar structure of the display substrate in the related art.
FIG. 2 schematically shows a schematic diagram of a planar structure of the first display substrate.
FIG. 3 schematically shows a schematic diagram of a planar structure of the first display substrate under the stretching state.
FIG. 4 schematically shows a schematic diagram of a planar structure of the second display substrate.
FIG. 5 schematically shows a schematic diagram of a planar structure of the second display substrate under the stretching state.
FIG. 6 schematically shows a schematic diagram of a planar structure of the third display substrate.
FIG. 7 schematically shows a schematic diagram of a planar structure of the third display substrate under the stretching state.
FIG. 8 schematically shows a schematic diagram of a sectional structure of the first display device.
FIG. 9 schematically shows a schematic diagram of a planar structure of the first display device before and after being stretched.
FIG. 10 schematically shows a schematic diagram of a sectional structure of the second display device.

### DETAILED DESCRIPTION

In order to make the purposes, the technical solutions and the advantages of the embodiments of the present disclosure more clearly, the technical solutions of the embodiments of the present disclosure will be clearly and completely described below with reference to the drawings of the embodiments of the present disclosure. Apparently, the described embodiments are merely certain embodiments of the present disclosure, rather than all of the embodiments. All of the other embodiments that a person skilled in the art obtains on the basis of the embodiments of the present disclosure without paying creative work will fall within the protection scope of the present disclosure.

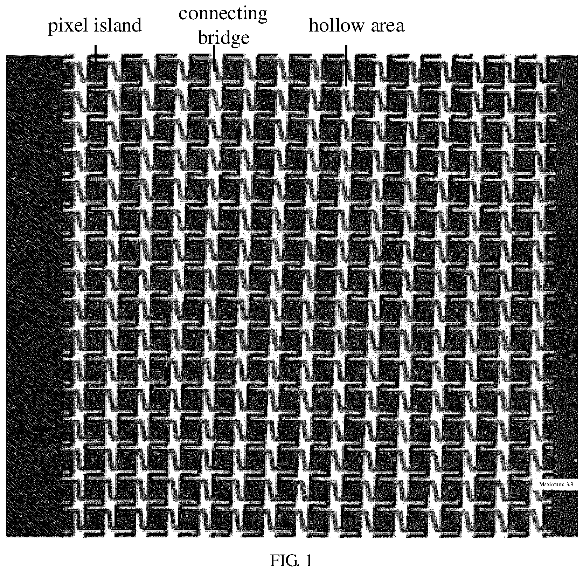

The stretchable display substrate generally adopts a structure in which a pixel island is connected to a connection bridge. A certain stretch rate can be achieved by deformation of a hollow area disposed between the pixel island and the connection bridge. However, as shown in FIG. 1, the stretching display substrate in the related art has a problem that deformation amounts at different positions of the display substrate under the stretching state are different. For example, as shown in FIG. 1, the deformation amounts of the connection bridges in the upper left corner and the lower right corner are larger, and the spacing between the adjacent pixel islands is larger, while the deformation amounts of the connection bridges in the upper right corner and the lower left corner are smaller, and the spacing between the adjacent pixel islands is smaller, which eventually causes the display substrate displaying unevenly.

After analyzing, the inventor finds that the connection bridges connected around the same pixel island are rotationally symmetrical. After the display substrate is subjected to the external tensile force, the connection bridge generates rotate torques and may not offset each other, so that steering force is generated, and the pixel island is driven to rotate, the problem that the deformation amounts at different positions are uneven is caused.

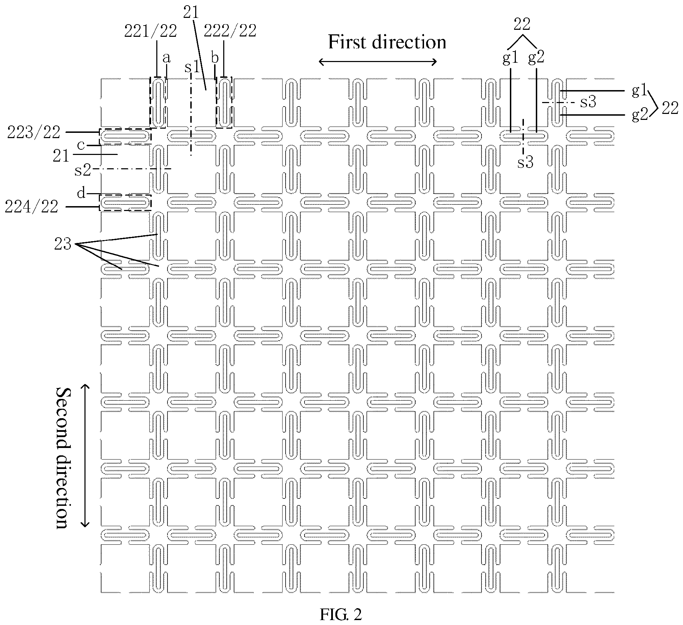

In order to solve the above-mentioned problem, the present disclosure provides a display substrate, as shown in FIG. 2, FIG. 4 or FIG. 6, the display substrate includes a plurality of display units 21 spaced apart from each other and a plurality of connecting units 22, the connecting unit 22 being connected between two adjacent display units 21. The plurality of connecting units 22 include two connecting units 221 and 222 arranged along a first direction, the first direction being parallel to a stretching direction of the display substrate.

As shown in FIG. 2, FIG. 4 or FIG. 6, the two connecting units 221 and 222 arranged along the first direction are axisymmetric about a first reference line s 1, to make the plurality of connecting units 22 arranged along a second direction have a same deformation amount under a stretching state, the second direction is perpendicular to the stretching direction, and an extension direction of the first reference line s 1 is parallel to the second direction.

As shown in FIG. 2, FIG. 4 or FIG. 6, the two connecting units 221 and 222 arranged along the first direction refer to the connecting unit 221 and the connecting unit 222, and the connecting unit 221 and the connecting unit 222 are arranged along the first direction.

Since the connecting unit 221 and the connecting unit 222 are axisymmetric about the first reference line s 1, and the first reference line s1 is perpendicular to the stretching direction (that is, the first direction), when the display substrate is stretched, even though the connecting unit 221 and the connecting unit 222 are subjected to the acting forces in other directions except the stretching direction, these acting forces may offset each other and may not generate a rotational torque, so that the total force acting on the connecting unit 221 and the connecting unit 222 is along the stretching direction. One or more display units 21 located between the connecting unit 221 and the connecting unit 222 are merely subjected to the acting force along the stretching direction, and may not rotate under the drive of the connecting unit 221 and the connecting unit 222, thus that the plurality of the connecting units 22 arranged along the second direction have the same deformation amount under the stretching state is ensured, so that the uniform spacing between adjacent display units 21 in the display substrate is ensured, and the display uniformity of the display substrate is improved.

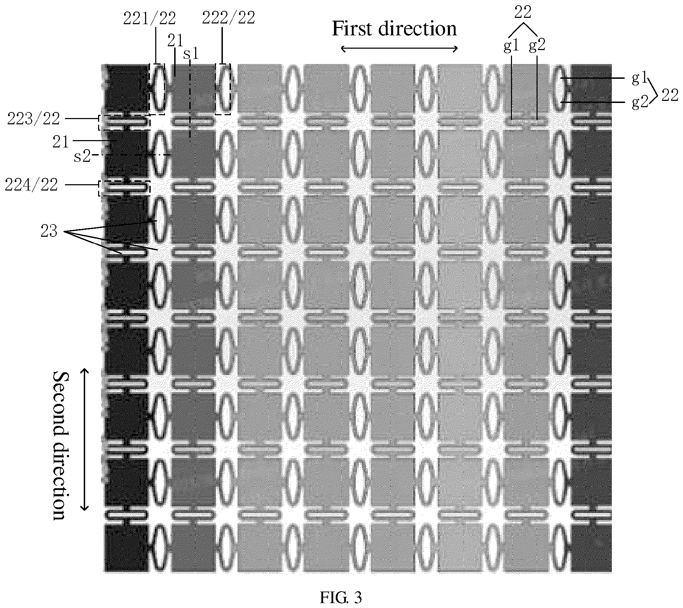

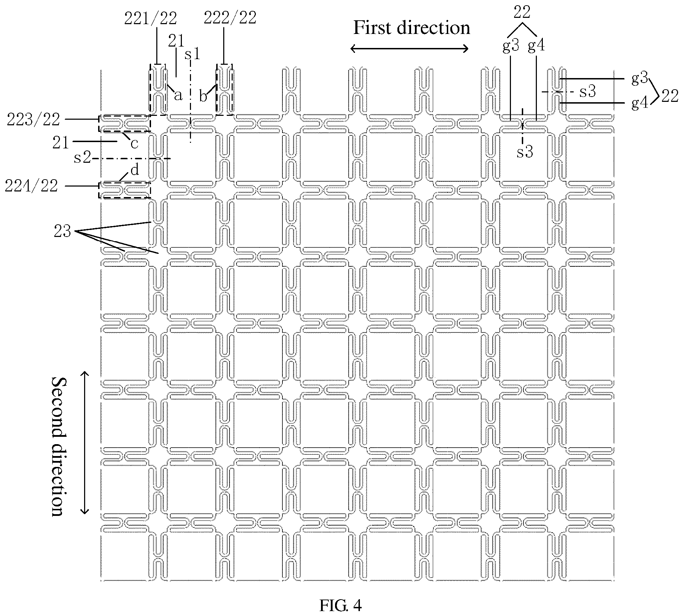

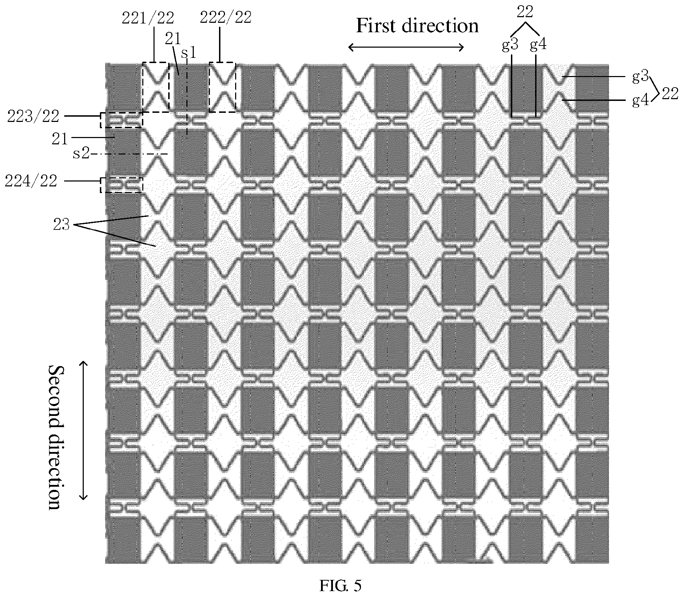

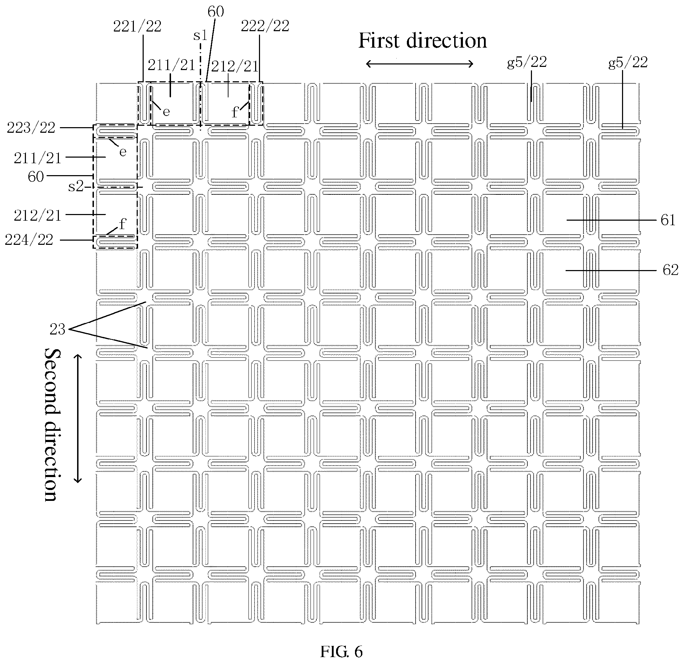

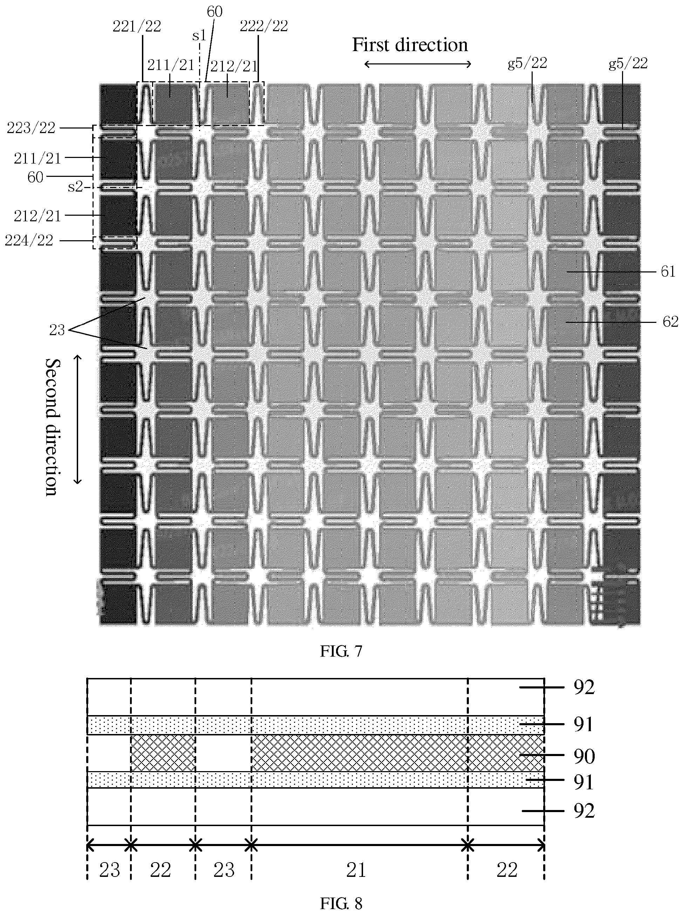

Referring to FIG. 3, which shows a schematic diagram of a planar structure of the display substrate shown in FIG. 2 under a stretching state. Referring to FIG. 5, which shows a schematic diagram of a planar structure of the display substrate shown in FIG. 4 under a stretching state. Referring to FIG. 7, which shows a schematic diagram of a planar structure of the display substrate shown in FIG. 6 under a stretching state. It may be seen from FIG. 3, FIG. 5 or FIG. 7 that, the deformation amounts of the plurality of connecting units 22 arranged along the second direction are same under the stretching state, and the spacing between the adjacent display units 21 in the display substrate is uniform.

As shown in FIG. 2, FIG. 4 or FIG. 6, the plurality of display units 21 spaced apart from each other are communicated with each other by means of the connecting units 22. Wherein, the display unit 21 is configured for displaying a picture and may include a plurality of sub-pixels, and every sub-pixel may include a thin film transistor and a light-emitting device. Wherein, the light-emitting device may be, for example, an organic light-emitting diode (OLED), a quantum dot light-emitting diode (QLED), a mini light-emitting diode (Mini LED) or a micro light-emitting diode (Micro LED) and the like, which is not limited by the present disclosure.

In practical implementation, the connecting unit 22 may be made of a highly elastic material for wiring and transferring stress during being stretched.

In some embodiments, as shown in FIG. 2, FIG. 4 or FIG. 6, the display substrate may further include a hollow area 23, the hollow area 23 is located between the display unit 21 and the connecting unit 22, and among the plurality of the connecting units 22, and the hollow area 23 penetrates through the display substrate in a normal direction of the display substrate. Wherein the hollow area 23 is configured for providing space for deformation during being stretched.

In some embodiments, as shown in FIG. 2, FIG. 4 or FIG. 6, the plurality of connecting units 22 further include: two connecting units 223 and 224 arranged along the second direction, and the two connecting units 223 and 224 arranged along the second direction are axisymmetric about a second reference line s2, and an extension direction of the second reference line s2 is parallel to the first direction.

As shown in FIG. 2, FIG. 4 or FIG. 6, the two connecting units 223 and 224 arranged along the second direction refer to the connecting unit 223 and the connecting unit 224, and the connecting unit 223 and the connecting unit 224 are arranged along the second direction.

Since the connecting unit 223 and the connecting unit 224 are axisymmetric about the second reference line s2, and the second reference line s2 is parallel to the stretching direction (i.e., the first direction), when the display substrate is stretched, even though the connecting unit 223 and the connecting unit 224 are subjected to the acting forces in other directions except the stretching direction, these acting forces may offset each other and may not produce the rotational torque, the total force acting on the connecting unit 223 and the connecting unit 224 is along the stretching direction. One or more display units 21 located between the connecting unit 223 and the connecting unit 224 are merely subjected to the force along the stretching direction, and may not rotate under the drive of the connecting unit 223 and the connecting unit 224, so that the plurality of the connecting units 22 arranged along the second direction have the same deformation under the stretching state is ensured, thereby that the uniform spacing between the adjacent display units 21 in the display substrate is ensured, and the display uniformity of the display substrate is improved.

It should be noted that, unless otherwise stated below, "two connecting units 22" may be the connecting unit 221 and the connecting unit 222 that are arranged along the first direction and are axisymmetric about the first reference line s1. Under this condition, the arrangement direction of the two connecting units 22 is the first direction. Furthermore, the "two connecting units 22" may also be the connecting unit 223 and the connecting unit 224 that are arranged along the second direction and are axisymmetric about the second reference line s2. Under this condition, the arrangement direction of the two connecting units 22 is the second direction.

In practical implementation, the two connecting units 22 may be connected to a same display unit 21 or may also be connected to different display units 21. These two cases are illustratively described in the following.

In a first example, as shown in FIG. 2 or FIG. 4, the two connecting units 22 are connected to a same display unit 21. The same display unit 21 has two side edges disposed oppositely in an arrangement direction of the two connecting units 22, and the two connecting units 22 are connected to different side edges in the two side edges respectively.

As shown in FIG. 2 or FIG. 4, the two connecting units 22 may be the connecting unit 221 and the connecting unit 222 arranged along the first direction, connecting the display unit 21 located between them. The display unit 21 has a side edge a and a side edge b. The side edge a and the side edge b are disposed oppositely in the first direction, wherein the connecting unit 221 is connected to the side edge a, and the connecting unit 222 is connected to the side edge b.

As shown in FIG. 2 or FIG. 4, the two connecting units 22 may also be the connecting unit 223 and the connecting unit 224 arranged along the second direction, connecting the display unit 21 located between them. The display unit 21 has a side edge c and a side edge d. The side edge c and the side edge d are disposed oppositely in the second direction, wherein the connecting unit 223 is connected to the side edge c, and the connecting unit 224 is connected to the side edge d.

Since the two axisymmetric connecting units 22 are located at two sides which are opposite of the same display unit 21, they are respectively connected to the different side edges which are opposite of the same display unit 21, it may be ensured that under the stretching state, the tensile force subjected to the display unit 21 is along the stretching direction, and the display unit 21 may not rotate under the action of the steering force, so that the uniformity of the spacing between the adjacent display units 21 in the display substrate is improved.

In some embodiments, as shown in FIG. 2, the connecting unit 22 includes a first connection line g1 and a second connection line g2, the first connection line g1 and the second connection line g2 are connected in parallel to each other between the two adjacent display units 21.

Wherein the first connection line g1 and the second connection line g2 are connected to a same side edge of a same display unit 21, and are connected to a same position on the same side edge. The same position may be any position on the same side edge.

In some embodiments, as shown in FIG. 2, the same position is located at a midpoint of the same side edge. That is, the first connection line g1 and the second connection line g2 are connected to the midpoint of the same side edge of the same display unit 21. In this way, the lengths of the first connection line g1 and the second connection line g2 may be maximally extended in a limited space, thereby the stretching rate of the display substrate is increased.

As shown in FIG. 2, if the first connection line g1 and the second connection line g2 are connected between two left-right adjacent display units 21, both of the first connection line g1 and the second connection line g2 are connected to the midpoint of the right side edge of the left side display unit 21, and both of the first connection line g1 and the second connection line g2 are connected to the midpoint of the left side edge of the right side display unit 21.

As shown in FIG. 2, if the first connection line g1 and the second connection line g2 are connected between the two upper-lower adjacent display units 21, both of the first connection line g1 and the second connection line g2 are connected to the midpoint of the lower side edge of the upper side display unit 21, and both of the first connection line g1 and the second connection line g2 are connected to the midpoint of the upper side edge of the lower side display unit 21.

In some embodiments, as shown in FIG. 2, the first connection line g1 is bend towards a side away from the second connection line g2, and the second connection line g2 is bend towards a side away from the first connection line g1.

In FIG. 2, both of the first connection line g1 and the second connection line g2 are U-shaped, and the U-shaped openings are disposed facing to each other. It should be noted that, the first connection line g1 and the second connection line g2 may also be other shapes, for example, S-shaped and the like, which are not limited in the present disclosure.

In some embodiments, as shown in FIG. 4, the connecting unit 22 includes a third connection line g3 and a fourth connection line g4, and the third connection line g3 and the fourth connection line g4 are connected in parallel to each other between the two adjacent display units 21.

Wherein the third connection line g3 and the fourth connection line g4 are connected to a same side edge of a same display unit 21, and are connected to different positions on the same side edge. The third connection line g3 and the fourth connection lineg4 may be connected to any two different positions on the same side edge.

In some embodiments, as shown in FIG. 4, the third connection line g3 and the fourth connection line g4 are connected to different endpoints of the same side edge respectively. That is, the third connection line g3 is connected to one endpoint of the same side edge, and the fourth connection line g4 are connected to the other endpoint of the same side edge. In this way, the lengths of the third connection line g3 and the fourth connection line g4 may be maximally extended in a limited space, thereby the stretching rate of the display substrate is increased.

As shown in FIG. 4, if the third connection line g3 and the fourth connection line g4 are connected between two left-right adjacent display units 21, the third connection line g3 is connected to the upper endpoint of the two side edges of the two left-right adjacent display units 21, wherein the two side edges are close to each other. The fourth connection line g4 is connected to the lower endpoint of the two side edges close to each other of the two left-right adjacent display units 21, wherein the two side edges are close to each other.

As shown in FIG. 4, if the third connection line g3 and the fourth connection line g4 are connected between the two upper-lower adjacent display units 21, the third connection line g3 is connected to the left endpoint of the two side edges of the two up-down adjacent display units 21, wherein the two side edges are close to each other. The fourth connection line g4 is connected to the right endpoint of the two side edges of the two up-down adjacent display units 21, wherein the two side edges are close to each other.

In some embodiments, as shown in FIG. 4, the third connection line g3 is bend towards a side close to the fourth connection line g4, and the fourth connection line g4 is bend towards a side close to the third connection line g3.

In FIG. 4, both of the third connection line g3 and the fourth connection line g4 are U-shaped, and the U-shaped openings are disposed facing away from each other. It should be noted that, the third connection line g3 and the fourth connection line g4 may also be other shapes, for example, S-shape and so on, which is not limited in the present disclosure.

In some embodiments, as shown in FIG. 2 and FIG.4, the connecting unit 22 includes two connection lines, the two connection lines are axisymmetric about a third reference line g3, and an extension direction of the third reference line g3 is parallel to an arrangement direction of the two display units 21 connected by each of the connection lines.

In FIG. 2, the two connection lines in the connecting unit 22 include a first connection line g1 and a second connection line g2. Under the condition that the first connection line g1 and the second connection line g2 are connected between the two left-right adjacent display units 21, the extension direction of the symmetry axis (i.e. the third reference line s3) of the first connection line g1 and the second connection line g2 is the first direction. If the first connection line g1 and the second connection line g2 are connected between the two upper-lower adjacent display units 21, the extension direction of the symmetry axis (i.e., the third reference line s3) of the first connection line g1 and the second connection line g2 is the second direction.

In FIG. 4, the two connection lines in the connecting unit 22 include the third connection line g3 and the fourth connection line g4. Under the condition that the third connection line g3 and the fourth connection line g4 are connected between the two left-right adjacent display units 21, the extension direction of the symmetry axis (i.e. third reference line s3) of the third connection line g3 and the fourth connection line g4 is the first direction. Under the condition that the third connection line g3 and the fourth connection line g4 are connected between the two upper-lower adjacent display units 21, the extension direction of the symmetry axis (i.e., the third reference line s3) of the third connection line g3 and the fourth connection line g4 is the second direction.

In a second example, as shown in FIG. 6, the two connecting units 22 are connected to different display units 21. Specifically, the display substrate includes at least one symmetric unit 60, and the symmetric unit 60 at least includes a first display unit 211 and a second display unit 212. An arrangement direction of the first display unit 211 and the second display unit 212 is parallel to an arrangement direction of the two connecting units 22.

Wherein, the first display unit 211 has a first side edge e away from the second display unit 212, the second display unit 212 has a second side edge f away from the first display unit 211, and the two connecting units 22 are connected to the first side edge e and the second side edge f respectively.

As shown in FIG. 6, the two connecting units 22 may be a connecting unit 221 and a connecting unit 222 arranged along the first direction, connecting the symmetric unit 60 between them, and the first display unit 211 and the second display unit 212 located in the symmetric unit 60 are arranged along the first direction. The first side edge e and the second side edge f are disposed facing to each other on the first direction, wherein the connecting unit 221 is connected to the first side edge e, and the connecting unit 222 is connected to the second side edge f.

As shown in FIG. 6, the two connecting units 22 may also be a connecting unit 223 and a connecting unit 224 arranged along the second direction, connecting the symmetric unit 60 located between them, and the first display unit 211 and the second display unit 212 located in the symmetric unit 60 are arranged along the second direction. The first side edge e and the second side edge f are disposed facing to each other on the second direction, wherein the connecting unit 223 is connected to the first side edge e, the connecting unit 224 is connected to the second side edge f.

As shown in FIG. 6, the two axisymmetric connecting units 22 are located at the two opposite sides of the same symmetric unit 60, connecting the first side edge e and the second side edge of the same symmetric unit 60 respectively, the first side edge e and the second side edge f are opposite to each other. The connecting unit 22 connected to the first side edge e and the connecting unit 22 connected to the second side edge f are axisymmetric, to ensure that under the stretching state, the tensile force subjected to the symmetrical unit 60 is along the stretching direction, and the symmetrical unit 60 may not rotate under the action of the steering force, so that the uniformity of the spacing between the adjacent display units, especially between the adjacent symmetrical units is improved.

In some embodiments, a shape of the display unit 21 is a polygon, the connecting unit 22 includes a fifth connection line g5, and the fifth connection line g5 is connected to a vertex of the polygon. In this way, the length of the fifth connection line g5 may be maximally extended in a limited space, thereby the stretching rate of the display substrate is increased.

In FIG. 6, the shape of the display unit 21 is a quadrilateral. Under the condition that the fifth connection line g5 is connected between two left-right adjacent quadrilaterals, one end of the fifth connection line g5 is connected to one vertex of the left quadrilateral, and the other end of the fifth connection line g5 is connected to one vertex of the right quadrilateral. Under the condition that the fifth connection line g5 is connected between two upper-lower adjacent quadrilaterals, one end of the fifth connection line g5 is connected to one vertex of the upper quadrilateral, and the other end of the fifth connection line g5 is connected to one vertex of the lower quadrilateral.

In some embodiments, a shape of the display unit 21 is a polygon, and a plurality of vertexes of the polygon are connected to different connecting units 22.

As shown in FIG. 6, a plurality of connecting units 22 connected to a polygon are connected with different vertexes respectively, the plurality of vertexes of the polygon are connected to different connecting units 22, that is, for each of the display units 21, one vertex of the polygon is connected to one connecting unit 22 in a one-to-one correspondence manner.

In FIG. 6, the shape of the display unit 21 is a quadrilateral with four vertexes. In a display unit 61, the lower left vertex is connected to a connecting unit 22 located at the left side of the display unit 21, the upper left vertex is connected to the connecting unit 22 located at the upper side of the display unit 21, the upper right vertex is connected to a connecting unit 22 located at the right side of the display unit 21, and the lower right vertex is connected to a connecting unit 22 located at the lower side of the display unit 21.

In a display unit 62, the lower left vertex is connected to a connecting unit 22 located at the lower side of the display unit 21, the upper left vertex is connected to a connecting unit 22 located at the left side of the display unit 21, the upper right vertex is connected to a connecting unit 22 located at the upper side of the display unit 21, and the lower right vertex is connected to a connecting unit 22 located at the right side of the display unit 21.

It should be noted that, the shape of the display unit 21 is not merely limited to the polygon, but also may be a circular, an elliptical and a fan-shaped and so on.

In some embodiments, as shown in FIG. 6, the first display unit 211 and the second display unit 212 are two adjacent display units 21.

In FIG. 6, the first display unit 211 and the second display unit 212 may be two left-right or up-down adjacent display units 21.

In some embodiments, as shown in FIG. 6, the connecting unit 22 each includes a fifth connection line g5, a shape of the fifth connection line g5 is a U-shaped, and U-shaped openings of the two adjacent fifth connection lines g5 face different directions respectively. Wherein the two adjacent fifth connection lines g5 are respectively located in two adjacent connecting units 22 arranged along the first direction or along the second direction.

As shown in FIG. 6, in the two adjacent connecting units 22 arranged along the first direction or the second direction, under the condition that the U-shaped opening of one of the fifth connection lines g5 faces to the right, the U-shaped opening of the other of the fifth connection lines g5 faces to the left. Under the condition that the U-shaped opening of one of the fifth connection lines g5 faces upwards, the U-shaped opening of the other of the fifth connection lines g5 faces downwards.

In some embodiments, the first display unit 211 and the second display unit 212 may also be non-adjacent, and at least one display unit 21 is further disposed between the first display unit 211 and the second display unit 212.

In some embodiments, the connecting unit 22 includes at least one connection line, each of the connection lines are connected to the two adjacent display units 21, and a shape of the connection line includes at least one of the following: curves for example U-shaped and S-shaped and the like, or broken lines.

In FIG. 2 and FIG. 4, each of the connecting units 22 include two U-shaped connection lines, for example, the first connection line g1 and the second connection line g2 in FIG. 2, or the third connection line g3 and the fourth connection line g4 in FIG. 4.

In FIG. 6, the connecting unit 22 includes a U-shaped connection line, for example the fifth connection line g5.

The present disclosure further provides a display device, including the display substrate according to any one of the embodiments; a driving integrated circuit configured to provide a driving signal to the display substrate; and a power supply circuit configured to provide a power supply to the display substrate.

A person skilled in the art may understand that the display device has the advantages of the previous display substrate.

Wherein the display device may be a displayer or a product containing a displayer. Wherein the displayer may be a flat panel display (FPD) and a micro-display and the like. In case that it is classified according to a scene whether a user is capable to see the back of the displayer, the displayer may be a transparent displayer or an opaque displayer. In case that it is classified according to whether the displayer may be bend or curl, the displayer may be a flexible displayer or an ordinary displayer (which may be referred to as a rigid display). Illustratively, the products containing the displayer may include: a computer, a television, an advertising board, a laser printer with display function, a telephone, a mobile phone, an electronic paper, a personal digital assistants (PDA), a laptop computer, a digital camera, a tablet computer, a notebook computer, a navigator, a portable video camcorder, a viewfinder, a vehicle, a large area wall, a theater screen or a stadium sign and so on.

As shown in FIG. 8, the display substrate 90 further includes a hollow area 23, the hollow area 23 penetrates through the display substrate 90 in a normal direction of the display substrate 90.

In practical implementation, as shown in FIG. 8, the display device may further include: a flexible substrate 92 disposed on at least one side of the display substrate 90; and an adhesive layer 91 disposed between the display substrate 90 and the flexible substrate 92.

Wherein, the flexible substrate 92 is a film material has high elasticity, for example polydimethylsiloxane and other silica gel. The adhesive layer 91 may include, for example, an optical adhesive.

As shown in FIG. 8, the flexible substrate 92 is disposed at the upper side and the lower side of the display substrate 90 respectively.

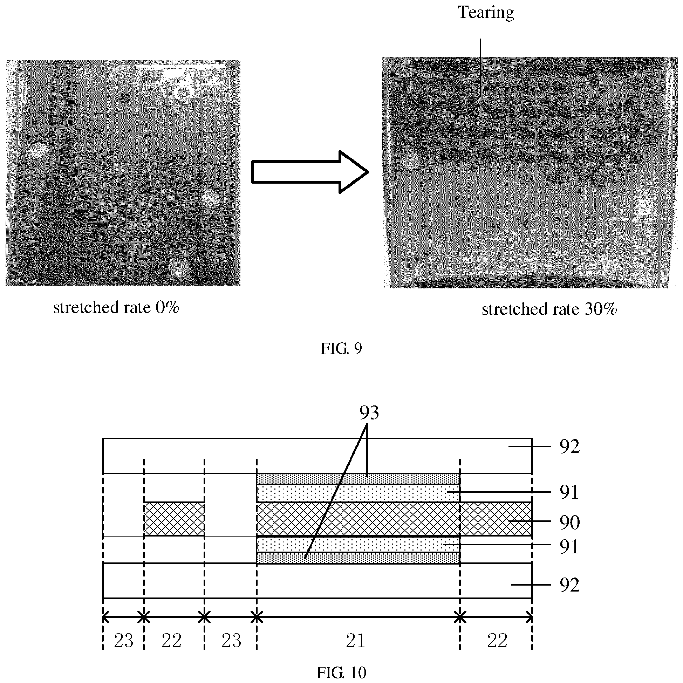

In FIG. 8, the orthographic projections of the flexible substrate 92 and the adhesive layer 91 on the display substrate 90 fully cover the display substrate 90. After such a display substrate 90 is repeatedly stretched, since the deformation amount of the connecting unit 22 is large, the material of the adhesive layer 91 is easily accumulated in the hollow area 23, causing it is easy to tear between the connecting unit 22 and the adhesive layer 91, as shown in FIG. 9.

To solve the problem stated above, in some embodiments, as shown in FIG. 10, an orthographic projection of the adhesive layer 91 on the display substrate 90 does not overlap with the connecting unit 22 and the hollow area 23. Since the connecting unit 22 and the hollow area 23 are provided with no adhesive layer 91, even though the connecting unit 22 and the hollow area 23 undergo large deformation during being stretched, the adhesive material accumulation and tearing may not occur.

In some embodiments, as shown in FIG. 10, the display device may also include a protective layer 93 disposed between the flexible substrate 92 and the adhesive layer 91, and the orthographic projection of the protective layer 93 on the display substrate 90 does not overlap with the connecting units 22 and the hollow area 23.

Wherein, the protective layer 93 may include an inorganic layer, a metal layer and a film material, for example polyimide and so on, which has high strength, and the film material may be formed by physical vapor deposition, chemical vapor deposition, spin coating or blade coating and so on. After the protective layer 93 is patterned, the adhesive material is coated on the protective layer 93 to adhere to the display units 21, and no adhesive material adhere to the connecting unit 22 and the hollow area 23. Since the protective layer 93 has high strength, it may not deform greatly with the increase of the stretching amount, so that the adhesive layer 91 at the corresponding position may be protected from failure, thus the generation of tearing is further avoided.

In the present disclosure, the meaning of "a plurality of" is two or more, and the meaning of "at least one" is one or more, unless otherwise specifically defined.

In the present disclosure, an orientation or positional relationship indicated by the terms "upper" and "lower" and the like is based on orientation or positional relationships shown in the drawings, and is merely for convenience of describing the present disclosure and simplifying the description, rather than indicate or imply that the device or element referred to must have a specific orientation, be constructed and operated in a specific orientation, and thus may not be understood as a limitation on the present disclosure.

In the claims, any reference symbols located between parentheses should not constitute a limitation on the claims.

In the present application, relational terms herein for example first and second and the like, are used merely for distinguishing one entity or operation from another entity or operation, and do not necessarily require or imply any such relationship or order exists between these entities or operations. Furthermore, the terms "include", "comprise" or any variations thereof are intended to cover a non-exclusive inclusion, so that a process, method, product, or apparatus including a series of elements includes not merely those elements, but also includes other elements not expressly listed, or also includes elements inherent to such a process, method, product, or apparatus. In the absence of further limitation, an element defined by the phrase "includes a ..." does not exclude the existence of other identical elements in the process, method, product, or apparatus.

The solution of the present disclosure is described in detail above. In the present application, specific examples are applied to explain the principle and implementation of the present disclosure herein. The above embodiments are merely used for helping understand the method of the present application and the core idea thereof.

Every embodiment in this specification is described in a progressive manner. Every embodiment focuses on the differences from the other embodiments, and the same or similar parts between the various embodiments may be referred to each other.

The "one embodiment", "an embodiment" or "one or more embodiments" as used herein means that particular features, structures or characteristics described with reference to an embodiment are included in at least one embodiment of the present disclosure. Moreover, it should be noted that, an example using the wording "in an embodiment" herein does not necessarily all refer to the same one embodiment.

The description provided herein describes many concrete details. However, it may be understood that, the embodiments of the present disclosure may be implemented without these concrete details. In some embodiments, well-known methods, structures and techniques are not described in detail, to not obscure the understanding of the description.

The present disclosure is intended to cover any variations, applications, or adaptive changes of the present disclosure. These variations, applications, or adaptive changes follow the general principles of the present disclosure and include common general knowledge or conventional technical means in the technical field, which are not disclosed herein. The specification and the embodiments are considered as being exemplary merely, with a true scope and spirit of the present disclosure being indicated by the following claims.

## Claims

1. A display substrate, **characterized in that** the display substrate comprises a plurality of display units spaced apart from each other and a plurality of connecting units, the connecting unit being connected between two adjacent display units;
the plurality of connecting units comprises: two connecting units arranged along a first direction, the first direction being parallel to a stretching direction of the display substrate;
wherein the two connecting units arranged along the first direction are axisymmetric about a first reference line, to make the plurality of connecting units arranged along a second direction have a same deformation amount under a stretching state, the second direction is perpendicular to the stretching direction, and an extension direction of the first reference line is parallel to the second direction.

2. The display substrate according to claim 1, **characterized in that** the plurality of connecting units further comprise: two connecting units arranged along the second direction, and the two connecting units arranged along the second direction are axisymmetric about a second reference line, and an extension direction of the second reference line is parallel to the first direction.

3. The display substrate according to claim 1 or claim 2, **characterized in that** the two connecting units are connected to a same display unit, and the same display unit has two side edges disposed oppositely in an arrangement direction of the two connecting units, and the two connecting units are connected to different side edges of the two side edges respectively.

4. The display substrate according to any one of claims 1-3, **characterized in that** the connecting unit comprises a first connection line and a second connection line, the first connection line and the second connection line are connected to a same side edge of a same display unit, and are connected to a same position on the same side edge.

5. The display substrate according to claim 4, **characterized in that** the same position is located at a midpoint of the same side edge.

6. The display substrate according to claim 5, **characterized in that** the first connection line is bend towards a side away from the second connection line, and the second connection line is bend towards a side away from the first connection line.

7. The display substrate according to any one of claims 1-3, **characterized in that** the connecting unit comprises a third connection line and a fourth connection line, the third connection line and the fourth connection line are connected to a same side edge of a same display unit, and are connected to different positions on the same side edge.

8. The display substrate according to claim 7, **characterized in that** the third connection line and the fourth connection line are connected to different endpoints of the same side edge respectively.

9. The display substrate according to claim 8, **characterized in that** the third connection line is bend towards a side close to the fourth connection line, and the fourth connection line is bend towards a side close to the third connection line.

10. The display substrate according to any one of claims 1-9, **characterized in that** the connecting unit comprises two connection lines, the two connection lines are axisymmetric about a third reference line, and an extension direction of the third reference line is parallel to an arrangement direction of the two display units connected by each of the connection lines.

11. The display substrate according to claim 1 or claim 2, **characterized in that** the display substrate comprises at least one symmetric unit, the symmetric unit at least comprises a first display unit and a second display unit, an arrangement direction of the first display unit and the second display unit is parallel to an arrangement direction of the two connecting units;
wherein, the first display unit has a first side edge away from the second display unit, the second display unit has a second side edge away from the first display unit, and the two connecting units are connected to the first side edge and the second side edge respectively.

12. The display substrate according to claim 11, **characterized in that** a shape of the display unit is a polygon, the connecting unit comprises a fifth connection line, and the fifth connection line is connected to a vertex of the polygon.

13. The display substrate according to claim 11 or claim 12, **characterized in that** a shape of the display unit is a polygon, and a plurality of vertexes of the polygon are connected to the different connecting units respectively.

14. The display substrate according to any one of claims 11-13, **characterized in that** the first display unit and the second display unit are two adjacent display units.

15. The display substrate according to claim 14, **characterized in that** the connecting unit each comprises a fifth connection line, a shape of the fifth connection line is U-shaped, U-shaped openings of two adjacent fifth connection lines face different directions respectively.

16. The display substrate according to any one of claims 11-13, **characterized in that** at least one display unit is further disposed between the first display unit and the second display unit.

17. The display substrate according to any one of claims 1-16, **characterized in that** the connecting unit comprises at least one connection line, each of the connection lines are connected to the two adjacent display units, and a shape of the connection line comprises at least one of the following: U-shaped and S-shaped.

18. The display substrate according to any one of claims 1-17, **characterized in that** the display substrate further comprises a hollow area, the hollow area is located between the display unit and the connecting unit, and among the plurality of the connecting units, and the hollow area penetrates through the display substrate in a normal direction of the display substrate.

19. A display device, **characterized in that** the display device comprises:
the display substrate according to any one of claims 1-18;
a driving integrated circuit, configured to provide a driving signal to the display substrate; and
a power supply circuit, configured to provide a power supply to the display substrate.

20. The display device according to claim 19, **characterized in that** the display substrate further comprises a hollow area, the hollow area penetrates through the display substrate in a normal direction of the display substrate;
the display device further comprises:
a flexible substrate disposed on at least one side of the display substrate; and
an adhesive layer disposed between the display substrate and the flexible substrate;
wherein an orthographic projection of the adhesive layer on the display substrate does not overlap with the connecting unit and the hollow area.
